# EUROPÄISCHE PATENTSCHRIFT

(11) **EP 2 156 480 B1**
(45) Veröffentlichungstag und Bekanntmachung des Hinweises auf die Patenterteilung: **21.12.2011**
(21) Anmeldenummer: 08749848.1
(22) Anmeldetag: 29.04.2008
(51) Int. Cl.: H01L 41/09, B60J 1/17

(54) **PIEZOELEKTRISCHE ANTRIEBSVORRICHTUNG**
PIEZOELECTRIC DRIVE UNIT
DISPOSITIF D'ACTIONNEMENT PIÉZOÉLECTRIQUE

(30) Priorität: 07.05.2007 DE 102007021337
(43) Veröffentlichungstag der Anmeldung: 24.02.2010
(73) Patentinhaber: Robert Bosch GmbH, 70442 Stuttgart (DE)
(72) Erfinder: HAUSSECKER, Walter, 77830 Buehlertal (DE); WALLASCHEK, Jörg, 33106 Paderborn (DE); RIEGER, Vincent, 76139 Karlsruhe (DE); TWIEFEL, Jens, 33106 Paderborn (DE); HEMSEL, Tobias, 33449 Langenberg (DE); RISCHMUELLER, Volker, 71229 Leonberg (DE); GUENTHER, Dirk, 55270 Jugenheim (DE); FROEHLICH, Peter, Changsha Hunan 410100 (CN)
(86) Internationale Anmeldenummer: PCT/EP2008/055245
(87) Internationale Veröffentlichungsnummer: WO 2008/135457

(56) Entgegenhaltungen:
- EP-A- 1 152 522
- EP-A- 1 806 793
- WO-A-98/21760
- DE-A1- 4 445 642
- DE-A1- 19 906 468
- US-A- 3 360 665
- US-A1- 2004 251 782
- US-A1- 2005 073 219

## Beschreibung

### Stand der Technik

Die Erfindung geht aus von einer piezoelektrischen Antriebsvorrichtung sowie einem Verfahren zum Betreiben eines solchen nach der Gattung der unabhängigen Ansprüche.

Mit der WO 00/28652 A1 ist ein Ultraschall-Motor bekannt geworden, bei dem eine Rotorwelle mittels Ultraschall-Vibratoren in Drehung versetzt wird. Dabei sind zwei Ultraschall-Vibratoren rechtwinklig miteinander verbunden, wobei beide Vibratoren derart mit einer Wechselspannung versorgt werden, dass die beiden Vibratoren mit einer Phasendifferenz zueinander schwingen. Diese Schwingung erzeugt eine Bewegung eines Stößels, der die Rotorwelle in Drehung versetzt. Durch die Anordnung des Stößels auf den Längsachsen der Piezoaktoren kann nur ein relativ kleiner Hub erzeugt werden. Daher sind aufgrund der Ausbildung und der Betriebsweise der Vibratoren viele Ultraschall-Vibratoren notwendig sind, um ein ausreichendes Antriebsmoment zu erzeugen. Ein solcher Motor ist deshalb sehr teuer und benötigt eine aufwändige elektronische Ansteuerung und einen entsprechend großen Bauraum.

Weitere Antriebsvorrichtungen sind aus US 2004 / 0251782 A1, DE 44 45 642 A1, US 2005 / 0073219 A1 und EP 1 152 522 A2 bekannt. Die Dokumente DE 199 06 468 A1 und US 3 360 665 beschreiben vorgespannte piezoelektrische Elemente.

### Offenbarung der Erfindung

### Vorteile der Erfindung

Die erfindungsgemäße piezoelektrische Antriebsvorrichtung, sowie das Verfahren zum Betreiben einer solchen Vorrichtung mit den Merkmalen der unabhängigen Ansprüche hat den Vorteil, dass durch die Anordnung des Friktionselements auf einem Brückensteg eine Hebelwirkung erzielt werden kann, die die Stoßbewegung des Friktionselements, verstärkt und dadurch einen größerer Vorschub, der Relativbewegung erzeugt. Über die Festlegung des Abstands des Friktionselements senkrecht zur Längsachse des Piezoaktors kann die Verstärkung bzw. die zu übertragende Stoßkraft eingestellt werden, wodurch eine Anpassung für unterschiedliche Anwendungen möglich ist.

Durch die in den abhängigen Ansprüchen aufgeführten Maßnahmen sind vorteilhafte Weiterbildungen und Verbesserungen der in den abhängigen Ansprüchen angegebenen Ausführungen möglich. Wird der Brückensteg im wesentlichen senkrecht zur Längsrichtung des Piezoaktors angeordnet, wird die größte Verstärkung der Stößelbewegung erzielt. Dabei kann der Brückensteg einerseits als freier Hebelarm oder andererseits als Verbindungssteg zu einem zweiten Piezoaktor ausgebildet sein. Ist das Friktionselement als Fortsatz in Längsrichtung ausgebildet, kann die Längsschwingung des Piezoaktors besonders effektiv in eine Stoßbewegung in Längsrichtung umgesetzt werden.

Besonders vorteilhaft ist es, wenn das Friktionselement eine Stoßfläche aufweist, die zur Kraftübertragung an der korrespondierenden Reibfläche anliegt. Die Stoßfläche ist dabei im wesentlichen parallel zur Reibfläche und im wesentlichen senkrecht zur Längsrichtung des Piezoaktors ausgerichtet, um einen hohen Wirkungsgrad bei der Übertragung der Stoßbewegung auf die Reibfläche zu gewährleisten.

In einer bevorzugten Ausgestaltung der Erfindung sind genau zwei Piezoaktoren in etwa parallel zueinander angeordnet, wobei der Brückensteg zwischen den beiden Piezoaktoren den Abstand quer zur Längsrichtung vorgibt. Bei dieser Ausbildung, kann das Friktionselement auf den Brückensteg wahlweise durch einen der beiden Piezoaktoren oder durch eine gemeinsame Anregung der beiden Piezoaktoren in eine Stoß- oder eine Ellipsenbewegung versetzt werden. Das Friktionselement ist bevorzugt als Stößel ausgebildet, der eine größere Ausdehnung in Längsrichtung aufweist als seine Ausdehnung in Querrichtung. Ist das Friktionselement mittig am Brückensteg befestigt, können bei wahlweiser Anregung des einen oder des anderen Piezoaktors symmetrische Bewegungen des Friktionselements erreicht werden, wobei die Stoßrichtung der Querkomponente entgegengesetzt zueinander ausgebildet ist. Dadurch kann die Relativbewegung in beide Richtungen mit den gleichen Kräften beziehungsweise Vorschüben realisiert werden.

Durch die gewölbte Ausbildung der Stoßfläche kann die Stoßkraft, besonders bei einer Ellipsenbewegung des Stößels, optimal auf die Reibfläche übertragen werden Zusätzlich kann die Stoßfläche mit einer zusätzlichen Schicht beaufschlagt werden, die die Reibung zur Reibfläche erhöht.

Besonders wirtschaftlich können der Brückensteg und das Friktionselement als separate Bauteile gefertigt werden, die dann mit den Piezoaktoren zum Piezomotor zusammengebaut werden können. Alternativ können die Gehäuse der Piezoaktoren auch einstückig mit dem Brückensteg und/oder dem Friktionselement ausgebildet sein, wodurch entsprechende Montageschritte entfallen.

Besonders günstig kann das Gehäuse des Piezoaktors als Hohlkörper ausgebildet werden, in dessen Inneren das Piezoelement eingefügt werden kann. Dabei ist das Gehäuse beispielsweise aus Metall, das gegenüber dem Piezoelement elektrisch isoliert ist.

Um eine größere mechanische Amplitude des Piezoelements zu erzielen, ist dieses vorteilhaft als Multilayer-Keramik oder Stapel-Keramik ausgebildet, so dass sich die Amplituden der einzelnen Schichten aufaddieren. Diese Piezokeramiken werden in Längsrichtung im Piezogehäuse vorgespannt, um den Wirkungsgrad des Piezoelements zu erhöhen und deren Zerstörung zu verhindern.

Zum Vorspannen der Piezoelemente eignen sich besonders Schraubelemente, die in das Aktorgehäuse und/oder in den Brückensteg eingeschraubt werden können.

Der Brückensteg kann je nach gewünschtem Funktionsprinzip der Stößelbewegung eher biegeweich oder eher biegesteif ausgebildet werden. Die Steifigkeit des Brückenstegs kann durch dessen Materialwahl und Formgebung beeinflusst werden. Zur Realisierung eines biegeweichen Brückenstegs kann an diesem beispielsweise ein oder mehrere Bereiche mit entsprechenden Aussparungen angeformt werden, so dass dessen Materialquerschnitt reduziert wird und/oder gelenkig ausgebildet wird.

Zur elektrischen Kontaktierung der Piezoelemente kann am Aktorgehäuse günstig ein Kontaktelement angeordnet werden, an dem die Elektroden des Piezoelements mit der elektrischen Steuereinheit verbunden werden können.

Um eine größere mechanische Amplitude des Piezoelements zu erzielen, ist dieses vorteilhaft als Multilayer-Keramik oder Stapel-Keramik ausgebildet,

Wird die Piezokeramik in mehreren Schichten ausgebildet, zwischen denen Elektronen angeschlossen werden, lässt sich mit einer vorgegebenen Spannung eine größere Schwingungsamplitude erzeugen. Werden die Schichten quer zur Längsrichtung des Piezoaktors angeordnet, wird dadurch die Längsschwingung in Längsrichtung maximiert. Die Elektroden können dabei günstig zwischen den getrennten Keramikschichten angeordnet werden.

Zur Erzeugung einer großen Schwingungsamplitude des Piezoaktors in Längsrichtung ist die Piezokeramik im Piezogehäuse derart vorgespannt, dass im Schwingbetrieb in der Piezokeramik keine Zugkräfte auftauchen. Dadurch lässt sich ein Schwingsystem hoher Güte erzielen, das in Längsrichtung eine hohe Steifigkeit aufweist.

Bevorzugt wird der Piezoaktor nur in Längsschwingungen versetzt, so dass nur Schwingungskomponenten entlang der Längsrichtung mit der größten Ausdehnung des Piezoaktors angeregt werden. Dazu wird die Piezokeramik und die Ausbildung des Gehäuse des Piezoaktors entsprechend optimiert.

Das erfindungsgemäße Verfahren zum Betreiben piezoelektrischer Antriebsvorrichtungen hat den Vorteil, dass mittels einer Abstimmschaltung einer Elektronikeinheit der Piezomotor, beziehungsweise die komplette Antriebsvorrichtung in ihrer Resonanzfrequenz angeregt werden kann. Durch die Regelung auf den Null-Durchgang des Phasenverlaufs des Antriebssystems kann die Resonanzfrequenz sehr genau eingehalten werden, wodurch der Wirkungsgrad des Piezoaktors deutlich gesteigert werden kann. Durch den Betrieb der Piezoaktoren in ihrer Resonanzfrequenz wird deren Piezokeramik optimal ausgenutzt. Dadurch lässt sich bei relativ geringem Materialeinsatz der Piezokeramik große Auslenkung des Piezoaktors erzeugen, wodurch ein großer Vorschub, beziehungsweise ein großes Moment auf die korrespondierende Reibfläche übertragen werden kann. Durch den Resonanzbetrieb wird die Piezokeramik im Punkt ihrer höchsten Effizienz betrieben, wodurch die elektrische Verlustleistung stark reduziert wird und dadurch eine Erwärmung der Piezokeramik vermieden wird. Im Resonanzbetrieb wird die Piezokeramik, die Elektronikeinheit und die Spannungsquelle nicht mit einer Blindleistung belastet, wodurch die Elektronik einfacher ausgeführt werden kann und beispielsweise auf zusätzliche Schalter und Filterelemente verzichtet werden kann. Durch die Ausnützung der Dielektrizität der Piezokeramik werden keine störenden elektromagnetischen Felder erzeugt, noch wird der Betrieb der Piezokeramik durch äußere Magnetfelder merklich beeinträchtigt. Beim Betrieb des Piezoaktors im, Resonanzbetrieb, kann durch das Design des Piezoaktors die Amplitude und die Kraftübertragung des Piezoaktors an die korrespondierende Reibfläche angepasst werden. Aufgrund der hohen Leistungsdichte des Piezoaktors kann der Materialeinsatz der relativ kostenintensiven Piezokeramik reduziert werden, bzw. die Leistung des Piezoantriebs erhöht werden.

Aufgrund der einphasigen Anregung des Piezomotors kann auf eine zweite Elektronikeinheit/Abstimmschaltung pro Piezomotor verzichtet werden. Es muss nur ein einziges Anregungssignal generiert werden, das abwechselnd auf den einen oder den anderen Piezoaktor gegeben wird. Dies vereinfacht die Signalaufbereitung und die Koordination verschiedener Piezomotoren. Durch die Ansteuerung jeweils nur eines Piezoaktors eines Piezomotors wird dessen Ansteuerungselektronik wesentlich vereinfacht wird. Das Schwingverhalten des Piezomotors wird nur durch die eine einzige Anregungsfrequenz bestimmt, so dass die Bewegungsbahn des Stößels einfach vorgebbar ist. Bei äußeren Einflüssen, die die Resonanzfrequenz verstimmen, kann die Resonanzfrequenz wesentlich einfacher mit einer einphasigen Anregung nachgeführt werden. Ist die Längsrichtung des Piezoaktors im Ruhezustand im Wesentlichen senkrecht zur korrespondieren Reibfläche des Antriebelements ausgerichtet, so kann die Längsschwingung eines einzigen Piezoaktors effektiv in die eine oder die entgegengesetzte Bewegungsrichtungen der Relativbewegung gegenüber der Reibfläche umgesetzt werden.

Durch die Mikrostoßbewegung des Friktionselements gegenüber der korrespondierenden Reibfläche kann eine Relativbewegung erzeugt werden, ohne dass zusätzliche träge Massen in Bewegung gesetzt werden müssen. Durch eine geeignete Wahl der Reibpartner zwischen dem Friktionselement und der korrespondierenden Reibfläche kann die Schwingung des Piezoaktors sehr verlustarm in eine Linearbewegung oder Rotationsbewegung eines Antriebelements umgesetzt werden. Zur Unterstützung der Kraftübertragung kann zusätzlich zum Reibschluss ein Formschluss zwischen dem Friktionselement und der Reibfläche ausgebildet werden. Das Antriebselement mit der Reibfläche kann vorteilhaft als lineare Antriebsschiene oder als Rotorwelle ausgebildet werden. Durch die Haltekraft, mit dem das Friktionselement gegen die lineare Schiene oder den Rotationskörper gepresst wird, wird die tangentiale Bewegungskomponente des Friktionselements auf das Antriebselement übertragen. Besonders günstig ist es, den Piezomotor an dem beweglichen Teil zu befestigen, so dass sich dieser gegenüber einer ortsfesten Reibfläche mit dem beweglichen Teil wegbewegt. Beispielsweise kann der Piezomotor an einer Fensterscheibe befestigt werden, und sich entlang einer Reibfläche einer karosseriefesten Führungsschiene abstoßen. Durch die direkte Erzeugung einer linearen Bewegung ist eine sehr schnelle Ansprechzeit mit hoher Dynamik möglich. Durch das Mikrostoßprinzip kann eine äußerst präzise Positionierung des zu verstellenden Teils bei geringer Geräuschemission erzielt werden.

Erläuternde Beispiele sowie Ausführungsbeispiele der Erfindung sind in den Zeichnungen dargestellt und in der nachfolgenden Beschreibung näher erläutert. Es zeigen
- Fig. 1: Eine piezoelektrische Antriebsvorrichtung,
- Fig. 2: eine weitere Ausführung für einen Rotationsantrieb,
- Fig. 3: ein Piezoelement für den Einbau in den Piezoaktor gemäß Fig. 1,
- Fig. 4: eine schematische Darstellung zum Betreiben der Antriebsvorrichtung,
- Fig. 5: eine Resonanzkurve des Piezomotors,
- Fig. 6: eine Impedanzkurve für das piezoelektrische Antriebs-System,
- Fig. 7: eine weiteres Ausführungsbeispiel einer Antriebsvorrichtung mit integriertem Lastsensor,
- Fig. 8 a, b: Explosionsdarstellungen zweier erfindungsgemäßer Piezomotoren,
- Fig. 9 a, b: den schematische Erzeugung verschiedener Schwingungsformen, und
- Fig. 10 a,: b die Kraftübertragung der Stößelbewegung.

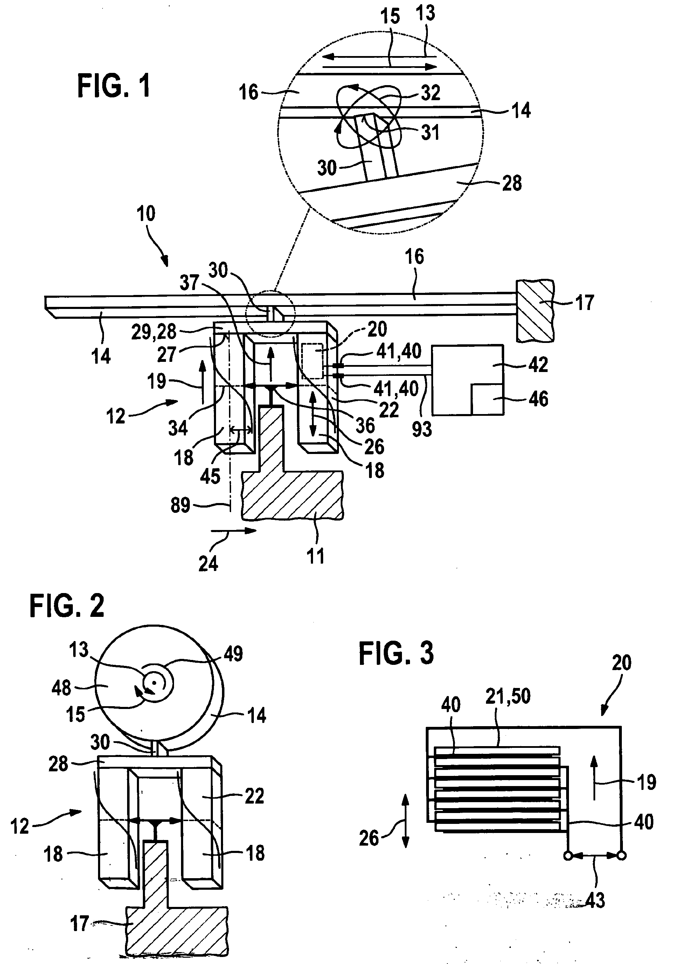

In Fig. 1 ist eine piezoelektrische Antriebsvorrichtung 10 dargestellt, bei der ein Piezomotor 12 eine Relativbewegung gegenüber einer korrespondierenden Reibfläche 14 ausführt. Die Reibfläche 14 ist hierbei als lineare Schiene 16 ausgebildet, die beispielsweise an einem Karosserieteil 17 befestigt ist. Der Piezomotor 12 weist mindestens einen Piezoaktor 18 auf, der wiederum ein Piezoelement 20 enthält. Hierzu weist der Piezoaktor 18 ein Aktorgehäuse 22 auf, das das Piezoelement 20 aufnimmt Das Aktorgehäuse 22 ist beispielsweise hülsenförmig ausgebildet. In der dargestellten Ausführungen ist das Piezoelement 20 vom Aktorgehäuse 22 umschlossen. Der Piezoaktor 18 weist eine Längsrichtung 19 auf, in deren Richtung die Ausdehnungen des Piezoaktors 18 größer ist als in einer Querrichtung 24 dazu. Das Piezoelement 20 ist vorzugsweise im Aktorgehäuse 22 in Längsrichtung 19 vorgespannt, derart, dass bei einer Anregung einer Längsschwingung 26 des Piezoelements 20 in diesem keine Zugkräfte auftreten. Durch die Schwingung des Piezoelements 20 wird der gesamte Piezoaktor 18 in Längsschwingung 26 versetzt und überträgt eine Schwingungsamplitude 45 über einen Brückensteg 28 auf ein Friktionselement 30, das in Reibkontakt zur Reibfläche 14 steht. Durch die Längsschwingung 26 des Piezoaktors 18 wird der Brückensteg 28 in eine Kippbewegung oder eine Biegebewegung versetzt, so dass ein der Reibfläche 14 zugewandtes Ende 31 des Friktionselements 30 eine Mikrostoßbewegung ausführt. Die Wechselwirkung zwischen dem Friktionselement 30 und der Reibfläche 14 ist in dem vergrößerten Ausschnitt dargestellt, in dem ersichtlich ist, dass der Brückensteg 28, der in Ruhestellung näherungsweise parallel zur Reibfläche 14 angeordnet ist, bei angeregter Schwingung des Piezoaktors 18 gegenüber der Reibfläche 14 verkippt. Dabei führt das Ende 31 des Friktionselements 30 beispielsweise näherungsweise eine Ellipsenbewegung 32 oder Kreisbewegung aus, mittels derer sich der Piezomotor 12 entlang der linearen Schiene 16 abstößt. Der Piezomotor 12 ist im Bereich von Schwingungsknoten 34 der Piezoaktoren 18 gelagert und beispielsweise mit einem zu bewegenden Teil 11 verbunden. Gleichzeitig wird der Piezomotor 12 über eine Lagerung 36 mit einer Normalkraft 37 gegen die Reibfläche 14 gedrückt. Dadurch führt das Ende 31 des Friktionselements 30 nun eine Ellipsenbewegung 32 aus, die zusätzlich zur Normalkraft 37 eine tangentiale Kraftkomponente 38 aufweist, die den Vorschub des Piezomotors 12 gegenüber der Reibfläche 14 bewirkt. In einer alternativen Ausführung führt das Friktionselement 30 lediglich eine lineare Stoßbewegung unter einem gewissen Winkel zur Normalkraft 37 aus. Dadurch kommt es ebenfalls zu einer Relativbewegung mittels Mikrostößen.

Im Ausführungsbeispiel gemäß Fig. 1 weist der Piezomotor 12 genau zwei Piezoaktoren 18 auf, die beide näherungsweise parallel zu ihrer Längsrichtung 19 angeordnet sind. Dabei ist der Brückensteg 28 quer zur Längsrichtung 19 angeordnet und verbindet die beiden Piezoaktoren 18 an ihren Stirnseiten 27. Der Brückensteg 28 ist beispielsweise als ebene Platte 29 ausgebildet, in deren Mitte das Friktionselement 30 angeordnet ist. In einer bevorzugten Betriebsweise der piezoelektrischen Antriebsvorrichtung 10 wird für eine Relativbewegung in eine erste Richtung 13 nur einer der beiden Piezoaktoren 18 angeregt. Dabei wirkt der zweite, nicht angeregte Piezoaktor 18 über den Brückensteg 28 als Schwingmasse, aufgrund derer der Brückensteg 28 mit dem Friktionselement 30 gegenüber der Längsrichtung 19 verkippt oder verbogen wird. Entsprechend der Steifigkeit des Aufbaus des Piezomotors 12 wird somit die Längsschwingung 26 des Piezoelements 20 in eine Mikrostoßbewegung mit einer tangentialen Kraftkomponente 38 umgewandelt. Die elektrische Anregung des Piezoelements 20 erfolgt über Elektroden 40, die über ein Kontaktierelement 41 mit einer Elektronikeinheit 42 verbunden sind. Für eine Bewegung des Piezomotors 12 in die entgegengesetzte Richtungen 15 wird entsprechend das Piezoelement 20 des anderen Piezoaktors 18 mittels der Elektronikeinheit 42 angeregt Bei dieser Betriebsweise ist immer nur ein Piezoelement 20 des Piezomotors 12 angeregt, so dass es zu keiner Überlagerung von zwei Schwingungsanregungen beider Piezoaktoren 18 kommen kann

Erfindungsgemäß wird die piezoelektrische Antriebsvorrichtung in ihrer Resonanzfrequenz 44 betrieben. Dazu weist die Elektronikeinheit 42 eine Abstimmschaltung 46 auf, die das entsprechende Piezoelement 20 derart ansteuert, dass das gesamte System in Resonanz schwingt. Die Elektronikeinheit 42 kann beispielsweise zumindest teilweise auch innerhalb des Aktorgehäuses 18 oder der Lagerung 36 angeordnet sein. In Fig. 1 sind in den beiden Piezoaktoren 18 jeweils die Amplituden 45 der Resonanzfrequenz 44 der Längsschwingung 26 dargestellt, wobei die beiden Piezoaktoren 18 bei dieser Betriebsweise nicht gleichzeitig angeregt werden. Die maximalen Amplituden 45 entsprechen hier der mechanische Resonanzfrequenz 44.

In Fig. 2 ist eine Variation der Antriebsvorrichtung 10 dargestellt, bei der der Piezomotor 12 in einem Karosserieteil 17 gelagert ist. Hingegen ist die Reibfläche 14 als Umfangsfläche eines Rotationskörpers 48 ausgebildet, so dass durch die Stößelbewegung des Friktionselements 30 der Rotationskörper 48 in Drehung versetzt wird. Entsprechend der zu Fig. 1 beschriebenen Betriebsweise kann die Drehrichtung 49 des Rotationskörpers 48 wiederum durch die Ansteuerung von jeweils nur einem Piezoelement 20 an einem der beiden Piezoaktoren 18 vorgegeben werden. Eine solche Antriebsvorrichtung 10 erzeugt eine Rotation als Antriebsbewegung und kann somit an Stelle eines Elektromotors mit nachgeschaltetem Getriebe eingesetzt werden.

In Fig. 3 ist vergrößerten Piezoelement 20 abgebildet, wie es beispielsweise im Piezomotor 12 der Fig. 1 oder 2 verwendet werden kann. Das Piezoelement 20 weist mehrere voneinander getrennte Schichten 50 auf, zwischen denen die jeweiligen Elektroden 40 angeordnet sind. Wird an den Elektroden 40 über die Elektronikeinheit 42 eine Spannung 43 angelegt, dehnt sich das Piezoelement 20 in Längsrichtung 19 aus. Die Ausdehnung der einzelnen Schichten 50 addiert sich auf, so dass durch die Anzahl der Schichten 50 die mechanische Gesamtamplitude 45 des Piezoelements 20 in Längsrichtung 19 vorgegeben werden kann. Die Schichten 20 sind dabei quer zur Längsrichtung 19 im Aktorgehäuse 22 angeordnet, so dass der gesamte Piezoaktor 18 durch das Piezoelement 20 in Längsschwingung 26 versetzt wird. Das Piezoelement 20 ist vorzugsweise aus einer Keramik 21 hoher Güte hergestellt, so dass im Resonanzbetrieb des Piezoelements 20 sehr große Amplituden 45 erzeugbar sind.

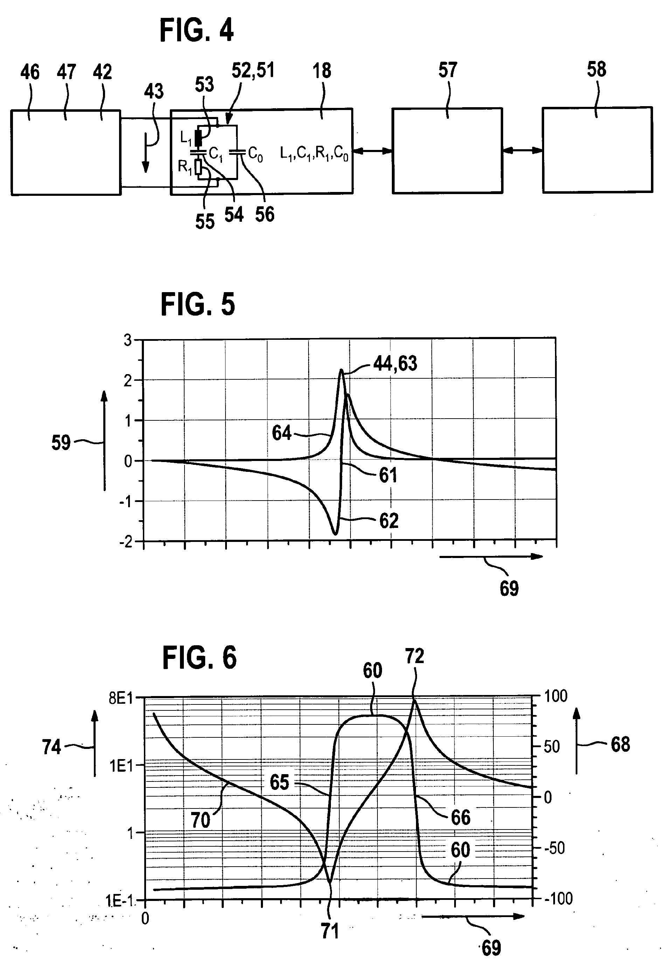

In Fig. 4 ist ein Modell der piezoelektrischen Antriebsvorrichtung 10 dargestellt, das als Grundlage zur Einstellung der Resonanzfrequenz 44 dient. Dabei ist der Piezoaktor 18 als Schwingkreis 52 dargestellt, in dem eine Induktivität 53 mit einer ersten Kapazität 54 und einer ohmschen Last 55 in Reihe geschaltet sind. Dazu ist eine zweite Kapazität 56 parallel geschaltet. An diesem Schwingkreis 52 wird eine Anregungsspannung 43 mittels der Elektronikeinheit 42 angelegt. Durch die Umwandlung der Längsschwingung 26 des Piezoaktors 18 in die Stößelbewegung des Friktionselements 30 wird die Resonanzfrequenz 44 des Piezoaktors 18 beeinflusst. Weiterhin hängt die Resonanzfrequenz 44 der gesamten Antriebsvorrichtung 10 von der Last 58 ab, die beispielsweise durch das Gewicht des zu verstellenden Teils 11 und/oder der Reibbedingung zwischen dem Friktionselement 30 und der Reibfläche 14 bestimmt wird.

Gemäß diesem Schaltbild stellt sich bei der Anregung der Verstellvorrichtung 10 mittels der Elektronikeinheit 42 ein Frequenzgang ein, wie er in Fig. 5 dargestellt ist. Hierbei ist die Leistung 59 über der Frequenz 69 aufgetragen. Beim Null-Durchgang 61 der dargestellten Blindleistung 62 ergibt sich ein Maximum 63 der Wirkleistung 64. Das Maximum 63 der Wirkleistung 64 tritt bei der Resonanzfrequenz 44 auf, auf die die piezoelektrische Antriebsvorrichtung 10 mittels der Abstimmschaltung 46 geregelt wird. Die Resonanzfrequenz 44 liegt beispielsweise im Bereich zwischen 30 und 80 kHz, vorzugsweise zwischen 30 und 50 kHz.

In Fig. 6 ist das dazugehörige Impedanzverhalten des Piezomotors 12 über den Frequenzgang dargestellt. Der Phasenverlauf 60 der Impedanz der durch den Schwingkreis 52 gemäß Fig. 4 dargestellten Verstellvorrichtung 10 weist einen ersten Null-Durchgang 65 mit positiver Steigung und einen zweiten Null-Durchgang 66 mit negativer Steigung auf, die der Serien- und der Parallelresonanz des Schwingkreises 52 entsprechen. Der Phasenwinkel 68 ist auf der Y-Achse auf der rechten Seite des Diagramms dargestellt. Um die Antriebsvorrichtung 10 im Resonanzbetrieb zu halten - beispielsweise auch bei einer veränderlichen Last 58 - regelt die Abstimmschaltung 46 die Frequenz 69 beispielsweise auf den Null-Durchgang 65 mit positiver Steigung, was elektronisch relativ einfach mittels einer Phasenregelschleife 47 (PLL: Phase Locked Loop) realisierbar ist. Die linke Y-Achse 74 stellt den Betrag 70 der Impedanz dar, wobei der Impedanzverlauf 70 über der Frequenz 69 ein Minimum 71 am ersten Null-Durchgang 65 und ein Maximum 72 am zweiten Null-Durchgang 66 aufweist.

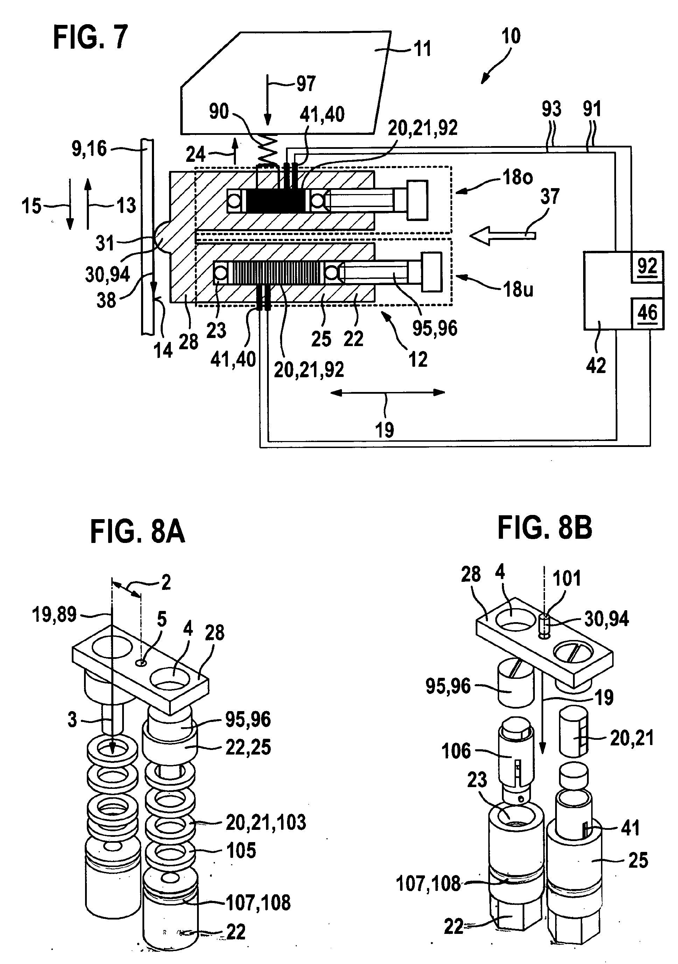

In Figur 7 ist ein weiteres Beispiel einer piezoelektrischen Antriebsvorrichtung 10 dargestellt, bei dem die lineare Schiene 16 als vertikale Führung 9 ausgebildet ist. Der Piezomotor 12 weist ebenso wie in Figur 1 und 2 zwei Piezoaktoren 18 auf, die in Längsrichtung 19 angeordnet sind. Die beiden Piezoaktoren 18 sind mittels eines Brückenstegs 28 miteinander verbunden, wobei dieser beispielsweise einstückig mit den beiden Aktorgehäusen 22 ausgebildet ist Am Brückensteg 28 ist wiederum ein Friktionselement 30 ausgebildet, das mit seinem Ende 31 in Reibverbindung mit der Reibfläche 14 der linearen Schiene 16 steht. Das Friktionselement 30 ist hier beispielsweise als gewölbter Stößel 94 ausgebildet, der eine Mikrostoßbewegung gegenüber der Schiene 16 ausführt. Im Inneren der beiden Aktorgehäuse 22 ist als Piezoelement 20 jeweils eine Piezokeramik 21 angeordnet, die in Längsrichtung 19 eine größere Ausdehnung aufweist, als in der Querrichtung 24. Die Piezoelemente 20 sind in Längsrichtung 19 mechanisch vorgespannt, wozu diese innerhalb eines Hohlraums 23 mittels Spannelementen 95 festgeklemmt sind. Die Spannelemente 95 sind beispielsweise als Schrauben 96 ausgebildet, die direkt in ein Gewinde des Aktorgehäuses 22 einschraubbar sind. Die Antriebsvorrichtung 10 ist hier als Fensterheberantrieb ausgebildet, bei dem der Piezomotor 12 mit dem zu verstellenden Teil 11 verbunden ist, das hier als Scheibe ausgebildet ist. Zur Ausführung einer Relativbewegung in erster Bewegungsrichtung 13 (Heben) wird gemäß dieser Ausführung nur der untere Piezoaktor 18u mittels der Elektronikeinheit 42 angesteuert. Durch die Anregung des unteren Piezoelements 20 führt das Friktionselement 30 eine Stoßbewegung oder Ellipsenbewegung 32 aus, wodurch sich der Piezomotor 12 mittels einer tangentialen Kraftkomponente 38 entlang der ersten Bewegungsrichtung 13 abstößt. Aufgrund der mechanischen Hysterese des am Piezoaktor 18 angeordneten Brückenstegs 28 wird die angeregte Längsschwingung 26 in eine elliptische Bewegung des Stößels 94 umgewandelt, die entsprechend den Systemparametern von einer reinen Linearbewegung abweicht. Dabei wird der Piezomotor 12 in Längsrichtung 19 mit einer Normalkraft 37 gegen die Reibfläche 14 gepresst.

Während der untere Piezoaktor 18u angeregt wird, wird an den oberen Piezoaktor 18o kein Anregungssignal 93 angelegt. Somit kann mit einer einzigen Elektronikeinheit 42, mit einer einzigen Abstimmschaltung 46 zeitlich nacheinander entweder der untere Piezoaktor 18u zum Heben des Teils 11 oder der obere Piezoaktor 18u zum Senken des Teils 11 angesteuert werden. Daher gibt es keine Überlagerung mehrerer Anregungssignale 93, wodurch der Piezomotor 12 immer nur einphasig angesteuert wird. Dabei kann für die Anregung des unteren Piezoaktors 18u und für die Anregung des oberen Piezoaktors 18o das identische Anregungssignal 93 verwendet werden, das durch die Abstimmschaltung 46 der Elektronikeinheit 42 generiert wird.

In Fig. 8a und 8b ist jeweils ein Piezomotor 12 in Explosionsdarstellung gezeigt, wobei zwei Piezoaktoren 18 mittels dem Brückensteg 28 miteinander verbunden sind. Die Piezoaktoren 18 weisen in Längsrichtung 19 eine größere Ausdehnung auf als in Querrichtung 24 und sind im Wesentlichen parallel zueinander angeordnet. Das Brückenelement 28 ist näherungsweise senkrecht zur Längsrichtung 19 angeordnet und erstreckt sich in etwa parallel zur korrespondierenden Reibfläche 14, wie dies in Fig. 1 dargestellt ist. In den Ausführungsbeispielen der Fig. 8a und 8b ist der Brückensteg 28 und das Friktionselement 30 jeweils als separates Bauteil ausgebildet, das dann mit dem Aktorgehäuse 22 zusammenmontiert wird. Dazu weist der Brückensteg 28 Aussparungen 4 auf, in die Spannelement 95 zur Erzeugung einer Vorspannung für das Piezoelement 20 einfügbar sind. In Fig. 8a besteht das Piezoelement 20 aus einer Stapel-Keramik 103, bei der mehrere Keramikringe 105 in Längsrichtung 19 aufeinander gestapelt werden und mittels dem Spannelement 95 gegeneinander verklemmt werden. Das Spannelement 95 ist als Schraube 96 ausgebildet, die einerseits in die Aussparung 4 einschraubbar oder einfügbar ist, und andererseits im Aktorgehäuse 22 eingeschraubt werden kann. Das Aktorgehäuse 22 ist beispielsweise als zylindrische Gehäusehülse 25 ausgebildet, die in Fig. 8a etwa einen gleichen Außendurchmesser aufweist, wie die Stapel- Keramik 103. In Fig. 8b hingegen ist das Piezoelement 20 als Multilayer-Keramik 104 ausgebildet, die einen geringeren Außendurchmesser aufweist als das Aktorgehäuse 22. Das Piezoelement 20 ist hierbei komplett im Hohlraum 23 des Aktorgehäuses 22 aufgenommen. Dabei ist das Piezoelement 20 mittels eines Isolierelements 106 gegenüber dem Aktorgehäuse 22 elektrisch isoliert. Das Aktorgehäuse 22 weist beispielsweise ein Innengewinde auf, in das die schraubenförmige Spannelemente 95 eingeschraubt werden. Das Brückenelement 28 weist eine weitere Aussparung 5 auf, in die das Friktionselement 30 eingefügt wird. Das Friktionselement 30 ist als Stößel 94 ausgebildet, der in Längsrichtung 19 eine größere Ausdehnung aufweist als in Querrichtung 24. Der Stößel 94 weist eine Stoßfläche 101 auf, die sich im wesentlichen parallel zum Brückensteg 28 und parallel zur korrespondierenden Reibfläche 14 erstreckt. Das Friktionselement 30 ist etwa in der Mitte zwischen den beiden Piezoaktoren 18 angeordnet und weist einen Abstand 2 zur Mittelachse 89 der Piezoaktoren 18 auf. Zur Lagerung der Piezoaktoren 18 mittels des Lagerelements 36 (siehe Fig. 1) ist am Aktorgehäuse 22 eine Aufnahme 107 ausgeformt, die beispielsweise als Ringnut 108 ausgebildet ist. Die Aufnahme 107 ist vorzugsweise im Bereich des Schwingungsknoten 34 des Piezoaktors 18 angeordnet. Alternativ zur zylindrischen Ausbildung des Aktorgehäuses 22 kann dieses auch einen viereckigen Querschnitt aufweisen, wie dies beispielsweise in Fig. 1 und 2 gezeigt ist.

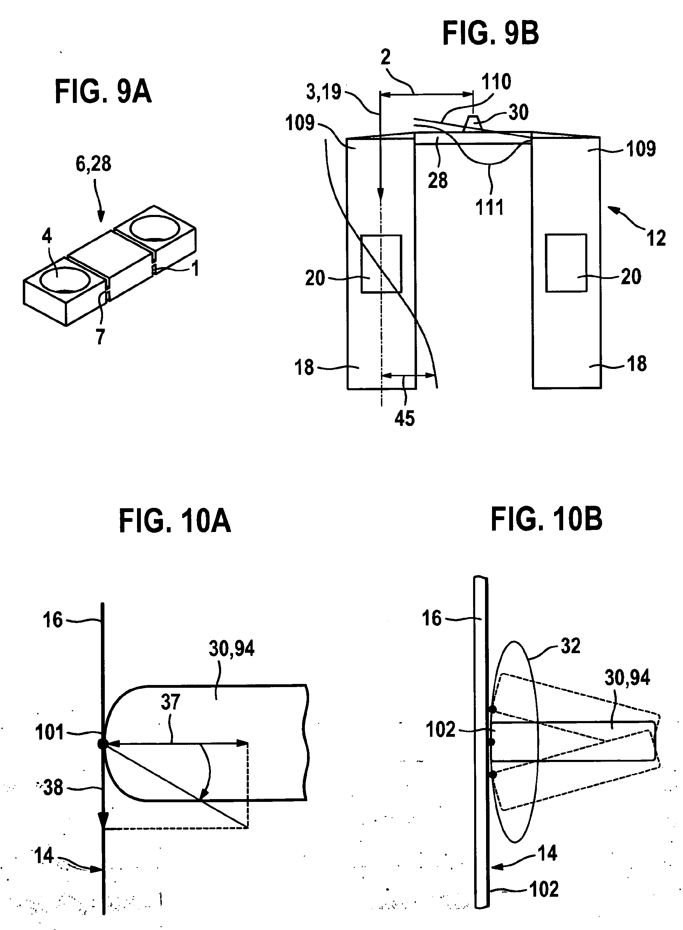

In Fig. 9A ist eine alternative Ausführung des Brückenstegs 28 dargestellt, wobei dieser als gelenkig an den Piezoaktor 18 angebundene biegesteife Platte 6 - bzw. Balken - ausgebildet ist. Um ein leichteres Verkippen des Brückenstegs 28 zu ermöglichen, weist die Platte 6 Bereiche 7 mit einem verringerten Materialquerschnitt auf. Diese Bereiche 7 sind quasi als gelenkige Bereiche ausgebildet, die ein Abknicken der Platte 6 ermöglichen. Dazu werden beispielsweise Schlitze 1 - insbesondere über die gesamte Breite des Brückenstegs 28 - in den Brückensteg 28 ausgeformt, deren Anzahl und Tiefe die Beweglichkeit des Brückenstegs 28 bestimmen. Eine alternative Ausführung des Brückenstegs kann durch eine kontinuierliche Veränderung des Materialquerschnitts über die Länge des Brückenstegs 28 ausgebildet werden, oder als biegeweiche Platte ausgebildet werden, wobei entsprechend biegeweiche Materialien verwendet werden. Zwischen den gelenkigen Bereichen kann biegesteifes oder biegeweiches Material angeordnet werden.

In Fig. 9B sind schematisch verschiedene Schwingungsformen des Piezomotors 12 dargestellt, die durch entsprechende Festlegung der Biegesteifigkeit des Brückenstegs 28 beziehungsweise des Aktorgehäuses 22 und dessen Zusammenbau bestimmt wird. Wird beispielsweise nur ein Piezoaktor 18 (links) mittels des Piezoelements 20 in Längsschwingung 26 versetzt, bewegt sich das obere Ende 109 des Piezoaktors 18 mit einer entsprechenden Amplitude 45 in Längsrichtung 19. Der zweite, nicht angeregte Piezoaktor 18 (rechts) wirkt zusammen mit dem Brückensteg 28 als passive Masse, die nur durch den ersten Piezoaktor 18 angeregt wird. Ist der Brückensteg 28 gelenkig angebunden und relativ biegesteif ausgebildet, so führt dieser auf der linken Seite eine Schwingung in Längsrichtung 19 aus, die stärker ist als auf der rechten Seite des Brückenstegs 28. Dies ist schematisch durch die eingezeichnete mechanische Schwingungsamplitude 110 des Brückenstegs 28 dargestellt. Dabei schwingt auch das Friktionselement 30 vorrangig in Längsrichtung 19. Jedoch hängen auch hier die Bewegungskomponenten des Friktionselements 30 und des Brückenstegs 28 von dem Abgleich der Resonanzfrequenzen der beiden Piezoaktoren 18 ab, so dass durch eine gezielte Verstimmung des Gesamtsystems auch eine Bewegungskomponente in Querrichtung 24 erzeugt werden kann. Eine solche Schwingungsform des Friktionselements 30 wird als "Tilting beam" bezeichnet. Werden hingegen bei einem gelenkig angebundenen biegesteifen Brückensteg 28 beide Piezoaktoren 18 gleichzeitig mit einem Phasenversatz angeregt (2-phasig), beispielsweise 90° versetzt, bewirkt dies ein Verkippen des Brückenstegs 28 um dessen Mittelpunkt, so dass das Friktionselement 30 eine so genannte "Shaking Beam"-Schwingung ausführt. Der Betrag und die Richtung der Relativbewegung an dem Friktionselement 30 und der Reibfläche 14 kann dabei durch die Einstellung des Phasenversatzes gesteuert werden.

Wird hingegen ein biegeweicher Brückensteg 28, beispielsweise eine biegeweiche Platte 6 verwendet, kann durch die Anregung eines Piezoaktors 18 in Längsschwingung 26 eine so genannte "La Ola"-Schwingung des Friktionselements 30 erzielt werden. Durch die Überlagerung von Biege- und Längsschwingung 26 bildet sich dann eine elliptische Bewegung des Friktionselements 30 aus. Hierbei kann die Biegebewegung des Brückenstegs 28 resonant abgestimmt werden, dies ist aber nicht zwingend notwendig ist. Die La Ola-Schwingung ist in Fig. 9B durch den Amplitudenverlauf 111 der mechanischen Schwingungen des Brückenstegs 28 dargestellt.

Die Steifigkeit des Brückenstegs 28 mit dem Aktorgehäuse 22 ist nicht zwangsläufig gleich mit der Steifigkeit des Piezoelements 20. Daher können beide Teile zwei verschiedene Antwortzeiten bezüglich ihrer Eigenschwingung haben, so dass bei zu niedriger Vorspannkraft das Risiko besteht, dass sich das Piezoelement 20 schneller zusammenzieht, als das Aktorgehäuse 22. Eine zu hohe Vorspannkraft hingegen würde die Schwingungsamplitude im quasistatischen Bereich zu sehr reduzieren. Daher wird die Vorspannung derart eingestellt, dass im Piezoelement 20 keine Zugkräfte im angeregten Zustand auftreten und dennoch möglichst hohe Schwingungsamplituden 45 im Resonanzbetrieb erzielt werden können. Die Spannelement 95 dienen auch zur Ableitung der im Piezoelement 20 generierten Wärme und sind daher aus einem Material mit guter Wärmeleitfähigkeit gefertigt.

In Fig. 10a und 10b ist nochmals schematisch dargestellt, wie durch die Bewegung des Friktionselements 30 eine Relativbewegung zur Reibfläche 14 erzeugt wird. Das Friktionselement 30 weist beispielsweise eine gewölbte Stoßfläche 101 auf, die jedoch im Bereich der Auflage an der Reibfläche 14 im wesentlichen parallel zu dieser ausgebildet ist. Dabei kann die Auflage als punkt- oder linienförmige Kontaktfläche ausgebildet sein. Das Friktionselement 30 wird mit der Normalkraft 37 gegen die Reibfläche 14 gedrückt. Der Normalkraft 37 wird die Stoß- oder Ellipsenbewegung 32 des Friktionselements 30 überlagert. Dabei tritt eine tangentiale Kraftkomponente 38 auf, die aufgrund der Reibung eine Relativbewegung entsprechend der Richtungen 13 oder 15 bewirkt. Dazu kann einerseits das Friktionselement 30 eine spezielle Beschichtung 102 aufweisen, die den Reibwert erhöht, und den Verschleiß der bewegten Teile reduziert. Ebenso kann andererseits die Reibfläche 14 eine spezielle Beschichtung 102 oder Oberflächenbeschaffenheit aufweisen, um die Reibpaarung zwischen der Reibfläche 14 und dem Friktionselement 30 zu verbessern. In Fig. 10b ist symbolisch beispielsweise die Ellipsenbewegung 32 des Friktionselements 30 dargestellt, die aufgrund der Reibpaarung zwischen dem Friktionselement 30 und der Reibfläche 14 in eine lineare Relativbewegung 13, 15 umgesetzt wird.

Es sei angemerkt, dass hinsichtlich der in den Figuren und der in der Beschreibung gezeigten Ausführungsbeispiel vielfältige Kombinationsmöglichkeiten der einzelnen Merkmale untereinander möglich sind. So kann beispielsweise die konkrete Ausbildung der Piezoaktoren 18, 8 deren Aktorgehäuse 22, der Piezolemente 20 (Monoblock, Stapel- oder, Multilayer), des Brückenstegs 28 und des Friktionselements 30 entsprechend der Anwendung variiert werden. Dabei kann die Stößelbewegung als reine Stoßbewegung oder als im wesentlichen elliptische oder kreisförmige Bewegungsbahn ausgebildet sein, wobei entsprechend der Querkomponente der Kraftübertragung die Reibpaarung zwischen dem Friktionselement 30 und der Reibfläche 14 eine höhere oder geringere Reibzahl aufweist. Dabei stellt die reine lineare Stößelbewegung den Grenzfall der Ellipsenbewegung dar. Als Grenzfall ist auch eine Ausbildung mit reinem Formschluss möglich, bei dem das Friktionselement 30 ohne Reibung in eine entsprechende Aussparung, beispielsweise in eine Mikroverzahnung des Antriebselements, z.B. der linearen Führungsschiene 16 oder des Rotationskörpers 48 greift. Der Winkel zwischen den Piezoaktoren 18 kann in einer alternativen Ausgestaltung auch von etwa 0° abweichen und bis zu 100° betragen. Ebenso kann die Längsrichtung des Stößels 94 unter einem Winkelbereich von 40° bis 90° zum Brückensteg 18 angeordnet werden, wobei auch die Stoßfläche 101 des Stößels 94 einen Winkel zur Reibfläche 14 und/oder zum Brückensteg 28 bilden kann. In einer weiteren Variation kann der Piezoaktor 18 auch mit einer Biegeschwingung betrieben werden, die sich beispielsweise mit der Längsschwingung 26 überlagert. Ebenso können bei mehr als zwei Piezoaktoren 18 die entsprechenden Schwingungen mehrerer Piezoaktoren eines Piezomotors 12 gleichzeitig ein- oder mehrphasig angeregt werden, wodurch eine Überlagerung dieser Schwingungen eine Stößelbewegung bewirkt, die das Antriebselement in Bewegung versetzt. Bevorzugt wird die erfindungsgemäße Antriebseinheit 10 zu Verstellung beweglicher Teile 11 im Kraftfahrzeug verwendet, ist jedoch nicht auf eine solche Anwendung beschränkt.

## Patentansprüche

1. Piezoelektrische Antriebsvorrichtung (10) zum Verstellen von beweglichen Teilen (11), insbesondere im Kraftfahrzeug, mit mindestens einem Piezomotor (12), der mindestens einen Piezoaktor (18) aufweist, wobei mittels mindestens eines Friktionselements (30) des Piezomotors (12) eine Relativbewegung bezüglich einer dem Friktionselement (30) gegenüberliegenden Reibfläche (14) erzeugbar ist, wobei das mindestens eine Friktionselement (30) an einem Brückensteg (28) des Piezomotors (12) angeordnet ist, der das Friktionselement (3) mit einem Abstand (2) zur in Längsrichtung (19) verlaufenden Mittelachse (89) des mindestens einen Piezoaktors (18) positioniert, wobei der Piezoaktor (18) ein Aktorgehäuse (22) aufweist, in dem das Piezoelement (20) mittels Spannelementen (95) vorgespannt ist, **dadurch gekennzeichnet, dass** Spannelement (95) als Schraube (96) ausgebildet ist, die einerseits in eine Aussparung (4) im Brückensteg (28) einschraubbar oder einfügbar ist, und andererseits in dem Aktorgehäuse (22) eingeschraubt werden kann.

2. Piezoelektrische Antriebsvorrichtung (10) nach Anspruch 1, **dadurch gekennzeichnet, dass** sich der Brückensteg (28) näherungsweise senkrecht zur Längsrichtung (19) erstreckt und sich das Friktionselement (30) näherungsweise in Längsrichtung (19) erstreckt.

3. Piezoelektrische Antriebsvorrichtung (10) nach einem der vorhergehenden Ansprüche, **dadurch gekennzeichnet, dass** zwei Piezoaktoren (18) näherungsweise bezüglich ihrer Längsrichtung (19) parallel zueinander mit einem Abstand (2) zueinander angeordnet sind und mittels des Brückenstegs (28) miteinander verbunden sind.

4. Piezoelektrische Antriebsvorrichtung (10) nach einem der vorhergehenden Ansprüche, **dadurch gekennzeichnet, dass** eine Stoßfläche (101) des Friktionselements (30) gewölbt ausgebildet ist, und insbesondere das Friktionselement (30) eine spezielle Beschichtung (102) aufweist, die den Reibwert erhöht, und den Verschleiß der bewegten Teile reduziert.

5. Piezoelektrische Antriebsvorrichtung (10) nach einem der vorhergehenden Ansprüche, **dadurch gekennzeichnet, dass** der Brückensteg (28) als separat gefertigte, ebene Platte ausgebildet ist, auf der insbesondere das separat gefertigte Friktionselement (30) befestigbar ist.

6. Piezoelektrische Antriebsvorrichtung (10) nach einem der vorhergehenden Ansprüche, **dadurch gekennzeichnet, dass** der mindestens eine Piezoaktor (18) als Aktorgehäuse (22) eine Gehäusehülse (25) aufweist, in deren Hohlraum (23) das Piezoelement (20) gegen die Gehäusehülse (25) elektrisch isoliert angeordnet ist.

7. Piezoelektrische Antriebsvorrichtung (10) nach einem der vorhergehenden Ansprüche, **dadurch gekennzeichnet, dass** der Brückensteg (28) einteilig mit dem Friktionselement (30) ausgebildet ist.

8. Piezoelektrische Antriebsvorrichtung (10) nach einem der vorhergehenden Ansprüche, **dadurch gekennzeichnet, dass** das Piezoelement (20) als Multilayer-Keramik (104) oder Stapelkeramik (103) ausgebildet ist.

9. Piezoelektrische Antriebsvorrichtung (10) nach Anspruch 8, **dadurch gekennzeichnet, dass** bei der Stapel-Keramik (103) mehrere Keramikringe (105) in Längsrichtung (19) aufeinander gestapelt werden und mittels dem Spannelement (95) gegeneinander verklemmt werden.

10. Piezoelektrische Antriebsvorrichtung (10) nach einem der vorhergehenden Ansprüche, **dadurch gekennzeichnet, dass** der Brückensteg (28) als biegeweiche Platte (6) ausgebildet ist, die insbesondere Bereiche mit einer reduzierten Materialstärke (7) aufweist.

11. Piezoelektrische Antriebsvorrichtung (10) nach einem der vorhergehenden Ansprüche, **dadurch gekennzeichnet, dass** der Brückensteg (28) als gelenkig mit mindestens einen der Piezoaktoren (18) verbundene Platte (6) ausgebildet ist, deren Bereiche zwischen den gelenkigen Verbindungen biegesteif oder biegeweich ausgebildet sind.

12. Piezoelektrische Antriebsvorrichtung (10) nach einem der vorhergehenden Ansprüche, **dadurch gekennzeichnet, dass** das Friktionselement (30) sich mittels Reibschluß und/oder Formschluß - insbesondere mittels einer formschlüssigen Mikrostruktur - an der Reibefläche (14) abstößt.

13. Piezoelektrische Antriebsvorrichtung (10) nach einem der vorhergehenden Ansprüche, **dadurch gekennzeichnet, dass** das Piezoelement (20) Elektroden (40) aufweist, die am Aktorgehäuse (22) ein Kontaktierelement (41) aufweisen mittels dem das Piezoelement (20) mit einer Elektronikeinheit (42) zur Ansteuerung der Piezokeramik (21) verbindbar ist.

14. Verfahren zum Betreiben einer piezoelektrischen Antriebsvorrichtung (10) nach einem der vorhergehenden Ansprüche **dadurch gekennzeichnet, dass** zwei Piezoaktoren (18) eines Piezomotors (12) mittels eines biegeweichen Brückenstegs (28) miteinander verbunden sind und die beiden Piezoaktoren (18) deutlich unterschiedliche Resonanzfrequenzen aufweisen, so das bei der Anregung nur eines der beiden Piezoaktoren (18) der andere nichtangeregte Piezoaktor (18) als feste Einspannung des Brückenstegs (28) agiert.

15. Verfahren zum Betreiben einer piezoelektrischen Antriebsvorrichtung (10) nach einem der vorhergehenden Ansprüche **dadurch gekennzeichnet, dass** pro Bewegungsrichtung (13, 15) nur einer der beiden Piezoaktoren (18) - insbesondere ausschließlich in Längsrichtung (19) - angeregt wird, und sich im Brückensteg (28) eine Biegewelle ausbildet, wobei die Biegebewegung nicht resonant abgestimmt werden braucht.

## Claims

1. Piezoelectric drive apparatus (10) for adjusting moving parts (11), in particular in a motor vehicle, having at least one piezo motor (12) which has at least one piezo actuator (18), it being possible to use at least one friction element (30) of the piezo motor (12) to generate a relative movement with respect to a frictional surface (14) which is situated opposite the friction element (30), with the at least one friction element (30) being arranged on a bridge web (28) of the piezo motor (12), which bridge web positions the friction element (30) at a distance (2) from the centre axis (89), which runs in the longitudinal direction (19), of the at least one piezo actuator (18), with the piezo actuator (18) having an actuator housing (22) in which the piezo element (20) is prestressed by means of clamping elements (95), **characterized in that** the clamping element (95) is in the form of a screw (96) which firstly can be screwed or inserted into a cutout (4) in the bridge web (28) and secondly can be screwed into the actuator housing (22).

2. Piezoelectric drive apparatus (10) according to Claim 1, **characterized in that** the bridge web (28) extends approximately perpendicular to the longitudinal direction (19), and the friction element (30) extends approximately in the longitudinal direction (19).

3. Piezoelectric drive apparatus (10) according to either of the preceding claims, **characterized in that** two piezo actuators (18) are arranged parallel to one another at a distance (2) from one another approximately with respect to their longitudinal direction (19) and are connected to one another by means of the bridge web (28).

4. Piezoelectric drive apparatus (10) according to one of the preceding claims, **characterized in that** an abutment surface (101) of the friction element (30) is curved, and in particular the friction element (30) has a special coating (102) which increases the coefficient of friction and reduces the wear on the moved parts.

5. Piezoelectric drive apparatus (10) according to one of the preceding claims, **characterized in that** the bridge web (28) is in the form of a separately produced, flat plate on which, in particular, the separately produced friction element (30) can be mounted.

6. Piezoelectric drive apparatus (10) according to one of the preceding claims, **characterized in that** the at least one piezo actuator (18) has, as an actuator (22), a housing sleeve (25), the piezo element (20) being arranged in the hollow space (23) in the said housing sleeve such that it is electrically insulated from the housing sleeve (25).

7. Piezoelectric drive apparatus (10) according to one of the preceding claims, **characterized in that** the bridge web (28) is integrally formed with the friction element (30).

8. Piezoelectric drive apparatus (10) according to one of the preceding claims, **characterized in that** the piezo element (20) is in the form of a multilayer ceramic (104) or a stacked ceramic (103).

9. Piezoelectric drive apparatus (10) according to Claim 8, **characterized in that**, in the stacked ceramic (103), a plurality of ceramic rings (105) are stacked one on top of the other in the longitudinal direction (19) and are clamped with respect to one another by means of the clamping element (95).

10. Piezoelectric drive apparatus (10) according to one of the preceding claims, **characterized in that** the bridge web (28) is in the form of a flexible plate (6) which has, in particular, regions with a reduced material thickness (7).

11. Piezoelectric drive apparatus (10) according to one of the preceding claims, **characterized in that** the bridge web (28) is in the form of a plate (6) which is connected in an articulated manner to at least one of the piezo actuators (18) and of which the regions between the articulated connections are rigid or flexible.

12. Piezoelectric drive apparatus (10) according to one of the preceding claims, **characterized in that** the friction element (30) butts against the frictional surface (14) by means of a frictional connection and/or interlocking connection - in particular by means of an interlocking microstructure.

13. Piezoelectric drive apparatus (10) according to one of the preceding claims, **characterized in that** the piezo element (20) has electrodes (40) which have a contact-making element (41) on the actuator housing (22), it being possible to use the said contact-making element to connect the piezo element (20) to an electronics unit (42) for the purpose of actuating the piezo ceramic (21).

14. Method for operating a piezoelectric drive apparatus (10) according to one of the preceding claims, **characterized in that** two piezo actuators (18) of a piezo motor (12) are connected to one another by means of a flexible bridge web (28) and the two piezo actuators (18) have clearly different resonant frequencies, so that when only one of the two piezo actuators (18) is excited, the other, non-excited piezo actuator (18) acts as a fixed clamping-in means for the bridge web (28).

15. Method for operating a piezoelectric drive apparatus (10) according to one of the preceding claims, **characterized in that** only one of the two piezo actuators (18) is excited - in particular solely in the longitudinal direction (19) - for each movement direction (13, 15), and a bending shaft is formed in the bridge web (28), it not being necessary to resonantly tune the bending movement.

## Revendications

1. Dispositif d'entraînement piézoélectrique (10) destiné à déplacer des pièces mobiles (11), en particulier dans un véhicule automobile, le dispositif présentant
au moins un piézomoteur (12) doté d'au moins un piézoactionneur (18), un déplacement relatif par rapport à une surface de frottement (14) opposée à un élément de friction (30) pouvant être formé au moyen d'au moins un élément de friction (30) du piézomoteur (12),
le ou les éléments de friction (30) étant disposés sur une traverse de pontage (28) du piézomoteur (12) qui positionne l'élément de friction (30) à une distance (2) de l'axe central (89), qui s'étend dans le sens de la longueur (19), du ou des piézoactionneurs (18),
le piézoactionneur (18) présentant un boîtier d'actionneur (22) dans lequel le piézoélément (20) est précontraint au moyen d'éléments de serrage (95), **caractérisé en ce que**
l'élément de serrage (95) est configuré comme vis (96) qui d'une part peut être vissée ou insérée dans une découpe (4) ménagée dans la traverse de pontage (28) et d'autre part peut être vissée dans le boîtier d'actionneur (22).

2. Dispositif d'entraînement piézoélectrique (10) selon la revendication 1, **caractérisé en ce que** la traverse de pontage (28) s'étend sensiblement à la perpendiculaire du sens de la longueur (19) et **en ce que** l'élément de friction (30) s'étend sensiblement dans le sens de la longueur (19).

3. Dispositif d'entraînement piézoélectrique (10) selon l'une des revendications précédentes, **caractérisé en ce que** deux piézoactionneurs (18) sont disposés avec leurs sens de la longueur (19) parallèles l'un à l'autre et à une distance (2) l'un de l'autre et sont reliés l'un à l'autre au moyen de la traverse de pontage (28).

4. Dispositif d'entraînement piézoélectrique (10) selon l'une des revendications précédentes, **caractérisé en ce qu'**une surface de butée (101) de l'élément de friction (30) a une configuration bombée et en particulier **en ce que** l'élément de friction (30) présente un revêtement spécial (102) qui augmente le coefficient de frottement en vue de réduire l'usure des pièces déplacées.

5. Dispositif d'entraînement piézoélectrique (10) selon l'une des revendications précédentes, **caractérisé en ce que** la traverse de pontage (28) est configurée comme plaque plane réalisée séparément et apte à être fixée en particulier sur l'élément de friction (30) réalisé séparément.

6. Dispositif d'entraînement piézoélectrique (10) selon l'une des revendications précédentes, **caractérisé en ce que** le ou les piézoactionneurs (18) présentent comme boîtier d'actionneur (22) une douille de boîtier (25) dans la cavité (23) de laquelle le piézoélément (20) est disposé de manière électriquement isolée vis-à-vis de la douille de boîtier (25).

7. Dispositif d'entraînement piézoélectrique (10) selon l'une des revendications précédentes, **caractérisé en ce que** la traverse de pontage (28) est formée d'un seul tenant avec l'élément de friction (30).

8. Dispositif d'entraînement piézoélectrique (10) selon l'une des revendications précédentes, **caractérisé en ce que** le piézoélément (20) est réalisé sous la forme d'une céramique multicouche (104) ou d'une céramique empilée (103).

9. Dispositif d'entraînement piézoélectrique (10) selon la revendication 8, **caractérisé en ce qu'**en cas d'une céramique empilée (103), plusieurs bagues (105) en céramique sont empilées les unes au-dessus des autres dans le sens de la longueur (19) et sont serrées les unes contre les autres au moyen de l'élément de serrage (95).

10. Dispositif d'entraînement piézoélectrique (10) selon l'une des revendications précédentes, **caractérisé en ce que** la traverse de pontage (28) est configurée comme plaque (6) déformable en flexion qui présente en particulier des parties dont l'épaisseur (7) du matériau est réduite.

11. Dispositif d'entraînement piézoélectrique (10) selon l'une des revendications précédentes, **caractérisé en ce que** la traverse de pontage (28) est configurée comme plaque (6) reliée de manière articulée à au moins l'un des piézoactionneurs (18) et dont les parties situées entre les liaisons articulées sont rigides ou déformables en flexion.

12. Dispositif d'entraînement piézoélectrique (10) selon l'une des revendications précédentes, **caractérisé en ce que** l'élément de friction (30) s'appuie sur la surface de friction (14) en correspondance de frottement et/ou en correspondance géométrique, en particulier au moyen d'une microstructure en correspondance géométrique.

13. Dispositif d'entraînement piézoélectrique (10) selon l'une des revendications précédentes, **caractérisé en ce que** le piézoélément (20) présente des électrodes (40) qui présentent sur le boîtier d'actionneur (22) un élément de mise en contact (41) au moyen duquel le piézoélément (20) peut être relié à une unité électronique (42) qui commande la piézocéramique (21).

14. Procédé d'utilisation d'un dispositif piézoélément d'entraînement (10) selon l'une des revendications précédentes, **caractérisé en ce que** deux piézoactionneurs (18) d'un piézomoteur (12) sont reliés l'un à l'autre au moyen d'une traverse de pontage (28) déformable en flexion, les deux piézoactionneurs (18) présentant des fréquences de résonance nettement différentes de sorte que lorsque seul un des deux piézoactionneurs (18) est excité, l'autre piézoactionneur (18) non excité agit comme serrage ferme de la traverse de pontage (28).

15. Procédé d'utilisation d'un dispositif piézoélément d'entraînement (10) selon l'une des revendications précédentes, **caractérisé en ce que** dans chaque direction (13, 15) de déplacement, seul l'un des deux piézoactionneurs (18) est excité, en particulier exclusivement dans le sens de la longueur (19), et **en ce qu'**une onde de flexion se forme dans la traverse de pontage (28), le déplacement de flexion ne devant pas être accordé en résonance.
